# EUROPEAN PATENT APPLICATION

(11) **EP 4 148 765 A1**
(43) Date of publication of application: **15.03.2023**
(21) Application number: 21195642.0
(22) Date of filing: 08.09.2021
(51) Int. Cl.: H01J 37/22

(54) **SEM IMAGE ENHANCEMENT**

(71) Applicant: ASML Netherlands B.V., 5500 AH Veldhoven (NL)
(72) Inventor: HUISMAN, Thomas, Jarik, 5500 AH Veldhoven (NL); VAN RENS, Jasper, Frans, Mathijs, 5500 AH Veldhoven (NL)
(74) Representative: ASML Netherlands B.V.

(57) **Abstract**

Disclosed herein is a method of reducing a sample charging effect in a scanning electron microscope (SEM) image, the method comprising:
obtaining a first SEM image of a target feature on a sample from a first electron beam scan in a first scanning direction;
obtaining a second SEM image of the target feature on the sample from a second electron beam scan in a second scanning direction different from the first scanning direction;
aligning the first SEM image and the second SEM image; and
generating an output image based a combination of the first SEM image and the second SEM image.

## Description

### TECHNICAL FIELD

The description herein relates to the field of image enhancement, and in particular to scanning electron microscopy (SEM) image enhancement.

### BACKGROUND

In manufacturing processes of integrated circuits (ICs), unfinished or finished circuit components are inspected to ensure that they are manufactured according to design and are free of defects. Inspection systems utilizing optical microscopes or charged particle (e.g., electron) beam microscopes, such as a scanning electron microscope (SEM) can be employed. As the physical sizes of IC components continue to shrink, and their structures continue to become more complex, accuracy and throughput in metrology process, including dimension metrology, defect detection and inspection, become more important.

However, when inspecting electrically insulating materials, the qualities of the SEM images (e.g. accuracy of measurement of critical dimension or edge placement error) typically suffer from SEM-induced charging artifacts. A known technique that is used in SEM imaging to reduce SEM-induced charging artifacts is averaging of a plurality of SEM images obtained using different scan directions. However, further improvements in the art are desired.

### SUMMARY

According to a first aspect of the invention, there is provided a method of reducing a sample charging effect in a scanning electron microscope (SEM) image, the method comprising:
obtaining a first SEM image of a target feature on a sample from a first electron beam scan in a first scanning direction;
obtaining a second SEM image of the target feature on the sample from a second electron beam scan in a second scanning direction different from the first scanning direction;
aligning the first SEM image and the second SEM image; and
generating an output image based a combination of the first SEM image and the second SEM image. According to a second aspect of the invention, there is provided a method comprising:
   obtaining a plurality of calibration SEM images by scanning a calibration feature in a plurality of different directions using a scanning electron microscope;
   determining one or more positional offsets for one or more of the calibration SEM images from the plurality of calibration SEM images such that the positional offsets can be used to generate an improved output image when combining a plurality of SEM images.

According to a third aspect of the invention, there is provided a method comprising:
obtaining a plurality of target SEM images by scanning a target feature in the plurality of different directions using a scanning electron microscope; and
combining the target SEM images to generate an output image;
wherein one or more positional offsets are applied during respective scans.

According to a fourth aspect of the invention, there is provided a method of measuring a parameter of a target feature on a sample using a scanning electron microscope (SEM) image, the method comprising:
obtaining a first SEM image of the target feature on the sample from a first electron beam scan in a first scanning direction;
obtaining a second SEM image of the target feature on the sample from a second electron beam scan in a second scanning direction different from the first scanning direction;
aligning the first SEM image and the second SEM image;
   generating an output image based a combination of the first SEM image and the second SEM image; and
determining the parameter from the output image.

### BRIEF DESCRIPTIONS OF FIGURES

Other advantages of the embodiments of the present disclosure will become apparent from the following description taken in conjunction with the accompanying drawings wherein are set forth, by way of illustration and example, certain embodiments of the present invention.
Fig. 1 is a schematic diagram illustrating an exemplary electron beam inspection (EBI) system, consistent with embodiments of the present disclosure.
Fig. 2 is a schematic diagram illustrating an exemplary electron beam tool, consistent with embodiments of the present disclosure that may be a part of the exemplary electron beam inspection system of Fig. 1.
Fig. 3 is an illustration of an example process of SEM-induced charging effect, consistent with embodiments of the present disclosure.
Fig. 4 is an example of an experimentally derived SEM image showing analysis of distortion believed to arise from charging effects in a single scan.
Fig. 5 is an example of a simulated SEM image having distortion arising from simulated charging effects in a single scan.
Fig. 6 is an example of simulated SEM images derived from different scan directions and their combination.
Fig. 7 is an example of an experimentally measured SEM image derived from a combination of four scans.
Fig. 8 is the image of Fig. 7 with distortion analysis applied.
Fig. 9 is an example of a simulated SEM image derived from a combination of four scans.
Fig. 10 is the image of Fig. 9 with distortion analysis applied.
Fig. 11 is a view similar to Fig 9 but with an alignment of component images consistent with the invention applied.
Fig. 12 is the image of figure 11 with distortion analysis applied.
Fig. 13 is an image of multiple contact holes obtained with a conventional process.
Fig. 14 is an image of multiple contact holes obtained with a method of an embodiment.
Fig. 15 is a flowchart of a method according to an embodiment. and
Fig. 16 is a flowchart of a method according to another embodiment.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations. Instead, they are merely examples of apparatuses and methods consistent with aspects related to the disclosed embodiments as recited in the appended claims. For example, although some embodiments are described in the context of utilizing electron beams, the disclosure is not so limited. Other types of charged particle beams may be similarly applied. Furthermore, other imaging systems may be used, such as optical imaging, photo detection, x-ray detection, etc.

Electronic devices are constructed of circuits formed on a piece of silicon called a substrate. Many circuits may be formed together on the same piece of silicon and are called integrated circuits or ICs. The size of these circuits has decreased dramatically so that many more of them can fit on the substrate. For example, an IC chip in a smart phone can be as small as a thumbnail and yet may include over 2 billion transistors, the size of each transistor being less than 1/1000th the size of a human hair. Making these extremely small ICs is a complex, time-consuming, and expensive process, often involving hundreds of individual steps. Errors in even one step have the potential to result in defects in the finished IC, thereby rendering it useless. Thus, one goal of the manufacturing process is to avoid such defects to maximize the number of functional ICs made in the process, that is, to improve the overall yield of the process.

One component of improving yield is monitoring the chip making process to ensure that it is producing a sufficient number of functional integrated circuits. One way to monitor the process is to inspect the chip circuit structures at various stages of their formation. Inspection can be carried out using a scanning electron microscope (SEM). A SEM can be used to image these extremely small structures, in effect, taking a "picture" of the structures. The image can be used to determine if the structure was formed properly and also if it was formed in the proper location. If the structure is defective (e.g. the wrong shape, size or place), then the process can be adjusted so the defect is less likely to recur. It may be desirable to have higher throughput for defect detection and inspection processes to meet the requirements of IC manufacturers.

However, the errors of the structures indicated by a SEM image may be "real" or may be "false." For example, when the SEM images the structure, distortions may appear in the image, causing the structure to appear deformed or misplaced, when, in reality, there are no errors in the formation or placement of the structure. The distortions may be caused by charges accumulating on the structures of the wafer after interacting with the electrons introduced during the scanning phase. The SEM may thus no longer generate images that faithfully represent the structures, leading to errors in measurements derived from the images.

The disclosure herein describes, among others, methods and systems for generating SEM images with reduced distortions. The SEM images generated according to methods disclosed herein, may thus be more faithful to the original structures, so that the ICs can be inspected with more accurate results, and no time is wasted on "false" errors due to misdiagnosis. In one example, two (or more) images are taken using different scanning directions. The two (or more) images are aligned to each other and then combined (e.g. by averaging) to create the image to be checked. The initial images, before combination into a final image, are sometimes referred to as frames. The alignment can be performed in advance by applying different offsets in the scanning process or after the scan by aligning the images. This approach has been found to result in more accurate measurements of the shape of features.

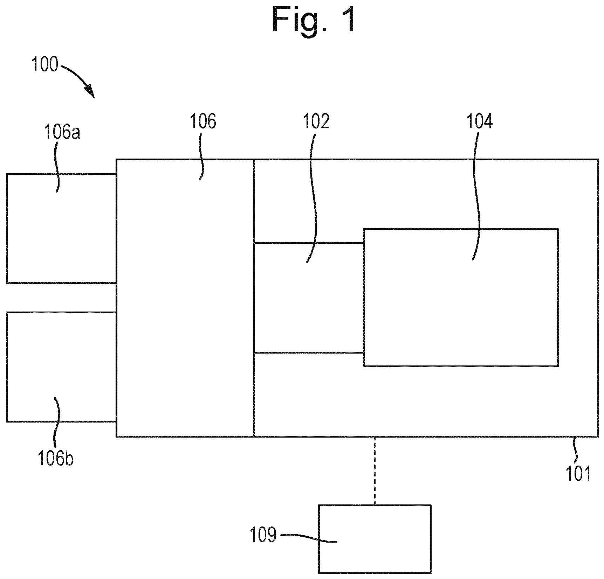

Reference is now made to Fig. 1, which illustrates an exemplary electron beam inspection (EBI) system 100 consistent with embodiments of the present disclosure. EBI system 100 may be used for imaging. As shown in Fig. 1, EBI system 100 may include a main chamber 101, a load/lock chamber 102, an electron beam tool 104, and an equipment front end module (EFEM) 106. Electron beam tool 104 is located within main chamber 101. While the description and drawings are directed to an electron beam, it is appreciated that the embodiments are not used to limit the present disclosure to specific charged particles.

EFEM 106 may include a first loading port 106a and a second loading port 106b. EFEM 106 may include additional loading port(s). First loading port 106a and second loading port 106b receive wafer front opening unified pods (FOUPs) that contain wafers (e.g., semiconductor wafers or wafers made of other material(s)) or samples to be inspected (wafers and samples may be used interchangeably).

One or more robotic arms (not shown) in EFEM 106 may transport the wafers to load/lock chamber 102. Load/lock chamber 102 is connected to a load/lock vacuum pump system (not shown) which removes gas molecules in load/lock chamber 102 to reach a first pressure below the atmospheric pressure. After reaching the first pressure, one or more robotic arms (not shown) may transport the wafer from load/lock chamber 102 to main chamber 101. Main chamber 101 is connected to a main chamber vacuum pump system (not shown) which removes gas molecules in main chamber 101 to reach a second pressure below the first pressure. After reaching the second pressure, the wafer is subject to inspection by electron beam tool 104. Electron beam tool 104 may be a single-beam system or a multi-beam system.

A controller 109 is electronically connected to electron beam tool 104 and may be electronically connected to other components as well. Controller 109 may be a computer configured to execute various controls of EBI system 100. Controller 109 may also include processing circuitry configured to execute various signal and image processing functions. While controller 109 is shown in Fig. 1 as being outside of the structure that includes main chamber 101, load/lock chamber 102, and EFEM 106, it is appreciated that controller 109 may be a part of the structure.

In some embodiments, controller 109 may include one or more processors (not shown). A processor may be a generic or specific electronic device capable of manipulating or processing information. For example, the processor may include any combination of any number of a central processing unit (or "CPU"), a graphics processing unit (or "GPU"), an optical processor, a programmable logic controllers, a microcontroller, a microprocessor, a digital signal processor, an intellectual property (IP) core, a Programmable Logic Array (PLA), a Programmable Array Logic (PAL), a Generic Array Logic (GAL), a Complex Programmable Logic Device (CPLD), a Field-Programmable Gate Array (FPGA), a System On Chip (SoC), an Application-Specific Integrated Circuit (ASIC), and any type circuit capable of data processing. The processor may also be a virtual processor that includes one or more processors distributed across multiple machines or devices coupled via a network.

In some embodiments, controller 109 may further include one or more memories (not shown). A memory may be a generic or specific electronic device capable of storing codes and data accessible by the processor (e.g., via a bus). For example, the memory may include any combination of any number of a random-access memory (RAM), a read-only memory (ROM), an optical disc, a magnetic disk, a hard drive, a solid-state drive, a flash drive, a security digital (SD) card, a memory stick, a compact flash (CF) card, or any type of storage device. The codes may include an operating system (OS) and one or more application programs (or "apps") for specific tasks. The memory may also be a virtual memory that includes one or more memories distributed across multiple machines or devices coupled via a network.

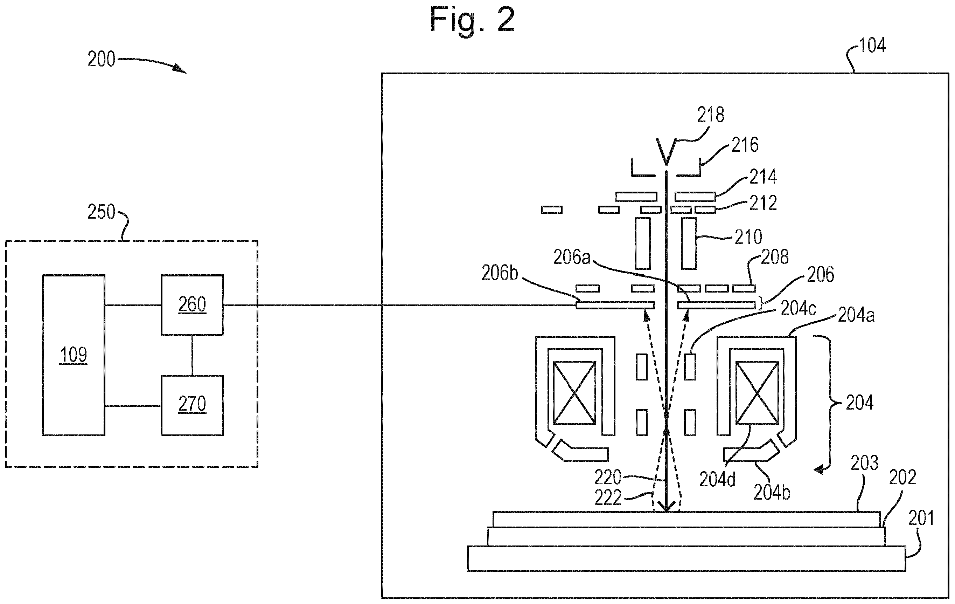

Reference is now made to Fig. 2, which illustrates an exemplary imaging system 200 according to embodiments of the present disclosure. Electron beam tool 104 of Fig. 2 may be configured for use in EBI system 100. Electron beam tool 104 may be a single beam apparatus or a multi-beam apparatus. As shown in Fig. 2 , electron beam tool 104 may include a motorized sample stage 201, and a wafer holder 202 supported by motorized sample stage 201 to hold a wafer 203 as an example of a sample to be inspected. Electron beam tool 104 may further include an objective lens assembly 204, an electron detector 206 (which includes electron sensor surfaces 206a and 206b), an objective aperture 208, a condenser lens 210, a beam limit aperture 212, a gun aperture 214, an anode 216, and a cathode 218. Objective lens assembly 204, in some embodiments, may include a modified swing objective retarding immersion lens (SORIL), which includes a pole piece 204a, a control electrode 204b, a deflector 204c, and an exciting coil 204d.

A primary electron beam 220 is emitted from cathode 218 by applying an acceleration voltage between anode 216 and cathode 218. Primary electron beam 220 passes through gun aperture 214 and beam limit aperture 212, both of which may determine the size of electron beam entering condenser lens 210, which resides below beam limit aperture 212. Condenser lens 210 focuses primary electron beam 220 before the beam enters objective aperture 208 to set the size of the electron beam before entering objective lens assembly 204. Deflector 204c deflects primary electron beam 220 to facilitate beam scanning on the wafer. For example, in a scanning process, deflector 204c may be controlled to deflect primary electron beam 220 sequentially onto different locations of top surface of wafer 203 at different time points, to provide data for image reconstruction for different parts of wafer 203. Moreover, deflector 204c may also be controlled to deflect primary electron beam 220 onto different sides of wafer 203 at a particular location, at different time points, to provide data for stereo image reconstruction of the wafer structure at that location. Further, in some embodiments, anode 216 and cathode 218 may generate multiple primary electron beams 220, and electron beam tool 104 may include a plurality of deflectors 204c to project the multiple primary electron beams 220 to different parts/sides of the wafer at the same time, to provide data for image reconstruction for different parts of wafer 203.

In many cases, the electron beam(s) of an SEM are scanned across the sample in a two-dimensional raster pattern. The raster pattern comprises a slow movement in a first direction and a fast movement in a second direction. The second direction is perpendicular, or nearly perpendicular, to the first direction. The first direction may be referred to as the main-scanning direction or the slow scan direction and the second direction as the sub-scanning direction or fast scan direction. Unless otherwise specified, the scan direction referred to herein is the fast scan direction. Scanning can also be performed mechanically, through stage movement, or by a combination of mechanical scanning and scanning by a deflector. For example, the slow scan may be performed by stage movement and the fast scan by the deflector.

Exciting coil 204d and pole piece 204a generate a magnetic field that begins at one end of pole piece 204a and terminates at the other end of pole piece 204a. A part of wafer 203 being scanned by primary electron beam 220 may be immersed in the magnetic field and may be electrically charged, which, in turn, creates an electric field. The electric field reduces the energy of impinging primary electron beam 220 near the surface of wafer 203 before it collides with wafer 203. Control electrode 204b, being electrically isolated from pole piece 204a, controls an electric field on wafer 203 to prevent micro-arching of wafer 203 and to ensure proper beam focus.

A secondary electron beam 222 may be emitted from the part of wafer 203 upon receiving primary electron beam 220. Secondary electron beam 222 may comprise secondary electrons, backscatter electrons and other electrons emitted by the wafer 203 as discussed below. Secondary electron beam 222 may form a beam spot on sensor surfaces 206a and 206b of electron detector 206. Electron detector 206 may generate a signal (e.g., a voltage, a current, or the like.) that represents an intensity of the beam spot, and provide the signal to an image processing system 250. The intensity of secondary electron beam 222, and the resultant beam spot, may vary according to the external or internal structure of wafer 203. Moreover, as discussed above, primary electron beam 220 may be projected onto different locations of the top surface of the wafer or different sides of the wafer at a particular location, to generate secondary electron beams 222 (and the resultant beam spot) of different intensities. Therefore, by mapping the intensities of the beam spots with the locations of wafer 203, the processing system may reconstruct an image that reflects the internal or surface structures of wafer 203.

Imaging system 200 may be used for inspecting a wafer 203 on sample stage 201 and includes an electron beam tool 104, as discussed above. Imaging system 200 may also include an image processing system 250 that includes an image acquirer 260, storage 270, and controller 109. Image acquirer 260 may include one or more processors. For example, image acquirer 260 may include a computer, server, mainframe host, terminals, personal computer, any kind of mobile computing devices, and the like, or a combination thereof. Image acquirer 260 may connect with a detector 206 of electron beam tool 104 through a medium such as an electrical conductor, optical fiber cable, portable storage media, IR, Bluetooth, internet, wireless network, wireless radio, or a combination thereof. Image acquirer 260 may receive a signal from detector 206 and may construct an image. Image acquirer 260 may thus acquire images of wafer 203. Image acquirer 260 may also perform various post-processing functions, such as generating contours, superimposing indicators on an acquired image, and the like. Image acquirer 260 may perform adjustments of brightness and contrast, or the like of acquired images. Storage 270 may be a storage medium such as a hard disk, cloud storage, random access memory (RAM), other types of computer readable memory, and the like. Storage 270 may be coupled with image acquirer 260 and may be used for saving scanned raw image data as original images, and post-processed images. Image acquirer 260 and storage 270 may be connected to controller 109. In some embodiments, image acquirer 260, storage 270, and controller 109 may be integrated together as one control unit.

In some embodiments, image acquirer 260 may acquire one or more images of a sample based on an imaging signal received from detector 206. An imaging signal may correspond to a scanning operation for conducting charged particle imaging. An acquired image may be a single image including a plurality of imaging areas. The single image may be stored in storage 270. The single image may be an original image that may be divided into a plurality of regions. Each of the regions may include one imaging area containing a feature of wafer 203.

In some embodiments, the SEM image may be an individual SEM image generated by a single scan of primary electron beam 220 on wafer 203 along a single scan direction. In some embodiments, the SEM image may be a first average SEM image generated by averaging multiple SEM images, each generated by a single scan of primary electron beam 220 on wafer 203 along the same scan direction. Embodiments of the present disclosure are not limited to any specific SEM image generated by any specific method, and the disclosed methods and systems may enhance SEM images that include, but are not limited to, the examples herein.

A challenge in defect detection is artifacts introduced by the inspection tools (e.g., a SEM). The artifacts do not originate from actual defects of the final products. They may distort or deteriorate the quality of the image to be inspected, and cause difficulties or inaccuracies in defect detection. For example, when inspecting electrically insulating materials using a SEM, the qualities of the SEM images typically suffer from SEM-induced charging artifacts.

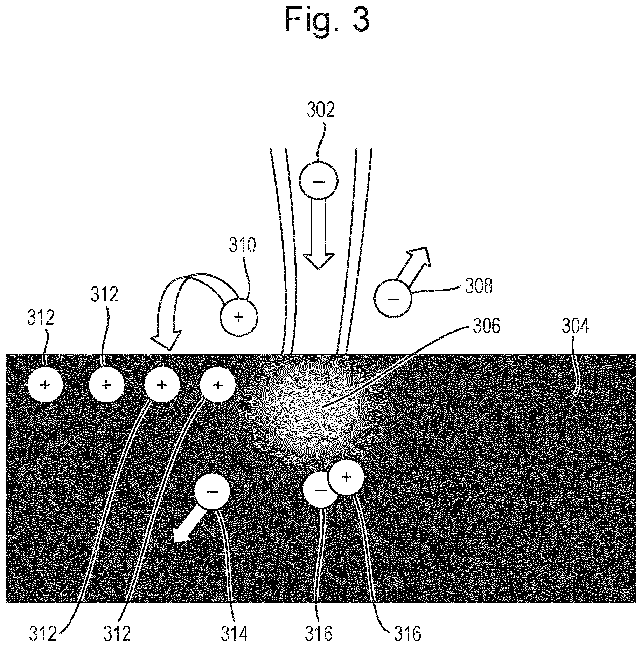

Reference is now made to Fig. 3, which is an illustration of an example process of SEM-induced charging effect, consistent with embodiments of the present disclosure. A SEM generates a primary electron beam (e.g., primary electron beam 220 in Fig. 2) for inspection. In Fig. 3, electrons of primary electron beam 302 are projected onto a surface of sample 304. Sample 304 may be of insulating materials, such as a non-conductive resist, a silicon dioxide layer, or the like. The electrons of primary electron beam 302 may penetrate the surface of insulator sample 304 for a certain depth, interacting with particles of insulator sample 304 in interaction volume 306.

Some electrons of primary electron beam 302 may elastically interact with (e.g., in a form of elastic scattering or collision) the particles in interaction volume 306 and may be reflected or recoiled out of the surface of sample 304. An elastic interaction conserves the total kinetic energies of the bodies (e.g., electrons of primary electron beam 302 and particles of sample 304) of the interaction, in other words no kinetic energy of the interacting bodies is converted to other forms of energy (e.g., heat, electromagnetic energy, etc.). Such reflected electrons generated from elastic interaction may be referred to as backscattered electrons (BSEs), such as BSE 308 in Fig. 3.

Some electrons of primary electron beam 302 may inelastically interact with (e.g., in a form of inelastic scattering or collision) the particles in interaction volume 306. An inelastic interaction does not conserve the total kinetic energies of the bodies of the interaction, in other words some or all of the kinetic energy of the interacting bodies is converted to other forms of energy. For example, through the inelastic interaction, the kinetic energy of some electrons of primary electron beam 302 may cause electron excitation and transition of atoms of the particles. Such inelastic interaction may also generate electrons exiting the surface of sample 304, which may be referred to as secondary electrons (SEs), such as SE 310 in Fig. 3.

Yield or emission rates of BSEs and SEs depend on, e.g., the energy of the electrons of primary electron beam 302 and the material under inspection, among others. The energy of the electrons of primary electron beam 302 may be imparted in part by its acceleration voltage (e.g., the acceleration voltage between anode 216 and cathode 218 in Fig. 2). The quantity of BSEs and SEs may be more or fewer (or even the same) than the injected electrons of primary electron beam 302. An imbalance of incoming and outgoing electrons can cause accumulation of electric charge (e.g., positive or negative charge) on the surface of sample 304. The extra charge may build up locally on or near the surface of sample 304, which may be referred to as a SEM-induced charging effect.

Typically, insulating materials (e.g., many types of resists) may be positively charged, because the number of outgoing electrons (e.g., BSEs or SEs) typically exceeds the number of incoming electrons of the primary electron beam of a SEM, and extra positive charge builds up on or near the surface of the insulator material. Fig. 3 shows a case where the SEM-induced charging effect occurs and causes positive charge accumulated on the surface of insulator sample 304. The positive charge may be physically modelled as holes 312. In Fig. 3, the electrons of primary electron beam 302 injected into interaction volume 306 may diffuse to the neighboring volume of interaction volume 306, which may be referred to as diffused electrons, such as diffused charge 314. The diffused electrons may recombine with positive charge (e.g., holes) in sample 304, such as recombination pair 316. The diffusion and recombination of charge may affect the distribution of holes 312. Holes 312 may cause a problem by, e.g., attracting BSEs and SEs back to the surface of sample 304, increasing the landing energy of the electrons of primary electron beam 302, causing the electrons of primary electron beam 302 to deviate from their intended landing spot, or interfering with an electric field between the surface of insulator sample 304 and an electron detector of BSEs and SEs, such as electron detector 206 in Fig. 2.

The SEM-induced charging effect may attenuate and distort the SEM signals received by the electron detector, which may further distort acquired SEM images. Also, because sample 304 is non-conductive, as primary electron beam 302 scans across its surface, positive charge may be accumulated along the path of primary electron beam 302. Such accumulation of positive charge may increase or complicate the distortion in the acquired SEM images. Such distortion caused by the SEM-induced charging effect may be referred to as SEM-induced charging artifacts. Because the charge accumulates mainly along the path of the primary electron beam 302, SEM-induced charging artifacts may primarily arise along the scan direction. The SEM-induced charging artifacts may induce error in estimating geometrical size of fabricated structures or cause misidentification of defects in an inspection. The present invention can address distortion and other errors caused by SEM-induced charging effects irrespective of the precise mechanism causing the charging effects.

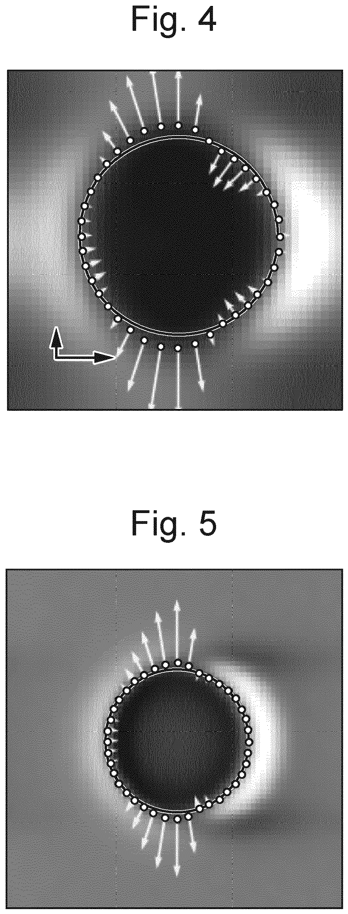

For example, Fig. 4, which is an SEM image obtained from a single scan performed in one direction (left to right), shows that the observed contact hole (CH) is deformed due to charging with respect to the expected circular shape indicated by the solid line circle. Whites dots indicate points on a contour fitted to the image and white arrows indicate the magnitude and direction of deformations of the dots from their expected locations. These deformations affect the observed width, placement and edge placement of the contact holes and other features, which are common metrics that are sought using SEM.

Fig. 5 is a similar image to Fig. 4 but derived from simulations, confirming the origin of the distortions.

To mitigate the deformations caused by SEM induced charging, it has been proposed to measure the same area using different fast scan directions and add the resulting frames together to form a SEM image. For example, a four scan process may comprise: a first scan in a first direction, e.g. parallel to an X axis of the SEM apparatus or the sample; a second scan in a second direction anti-parallel to the first direction; a third scan in a third direction orthogonal to the first direction, e.g. parallel to a Y axis of the SEM apparatus or the sample; and a fourth scan in a fourth direction anti-parallel to the third direction.

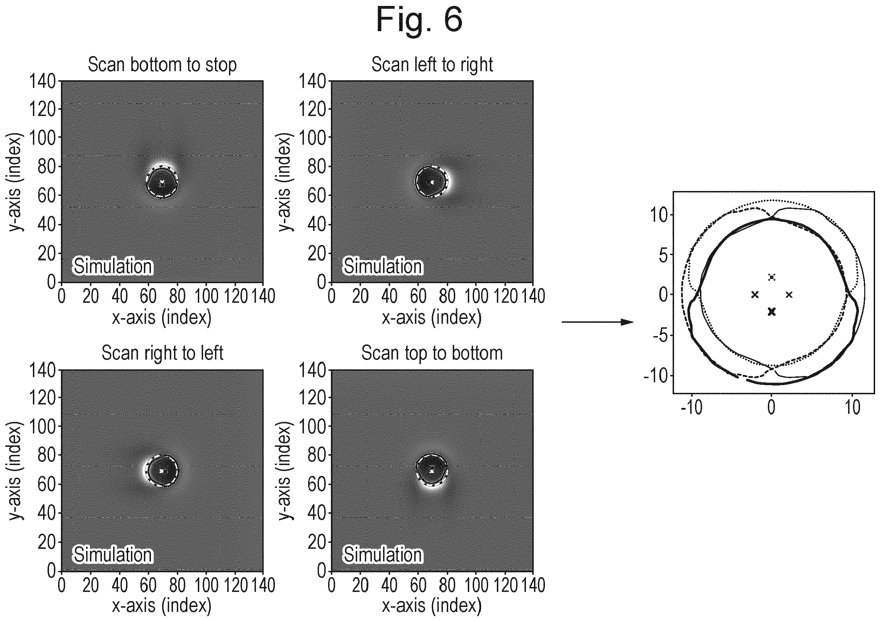

The present inventors have determined that a simple combination of images derived from four such scans still does not accurately represent the actual physical structure on the sample. It is believed that the inaccuracy arises because the combination of images does not take into account charging of the sample. As the apparent locations of features are displaced parallel to the fast scanning direction due to SEM induced charging, features measured in oppositely directed scans do not optimally overlap. Features are sometimes also displaced in a direction orthogonal to the fast scan direction, and this can also be addressed by the present method, but such displacements are usually smaller than displacements parallel to the fast scan direction. Fig. 6 illustrates why features in oppositely directed scans do not optimally overlap.

Fig. 6 shows on the left side four images obtained by scanning a feature using different scanning directions and contours fitted to the scans. On the right the contours and their centers are shown overlaid, from which it can be seen that they do not accurately overlap due to charging induced feature shift.

Therefore, the present invention proposes that images of a feature obtained using different scan directions should be aligned before being combined (e.g. by averaging) and that desirably the alignment is based on measurements taken on the actual stack of interest. In some cases it is possible to base the combination on measurements taken not on the exact structure but on a structure or stack that has similar charging effects as the wafer of interest.

The present invention can be implemented using two different approaches to alignment of images: alignment during the scanning process (e.g. in hardware), or alignment in post processing of images. If the post processing of images approach is taken, it is necessary to store the images from all the different scanning directions used. Therefore, it may be preferable to align the individual images during scanning. This can be implemented by setting an offset in space which effectively mitigates the charging induced feature shift in one or more scans. One approach to determining the optimal offset is to find the offset value for which the feature edges of the combined image are sharpest. An optimizer based on gradients can be used but other techniques are also effective. One or more offset values can be found for each pair of opposite direction scans (e.g. one for scans parallel and anti-parallel to the X direction and one for scans parallel to and anti-parallel to the Y direction). In some cases, it is sufficient to determine a single offset value for each pair of opposite direction scans; the images are then shifted in opposite directions by an amount determined by the offset value. It is also possible to separately align parts, e.g. lines, of the separate images rather than applying a single offset to the whole image.

The images obtained from the various scans can be combined to form a composite image by various methods, for example averaging. The offsets can also be used with a model based correction e.g. as described in co-pending patent application number EP 21163831.7 filed on March 19, 2021, entitled "SEM Image Enhancement", which document is hereby incorporated by reference in relation to the description of correction of SEM images.

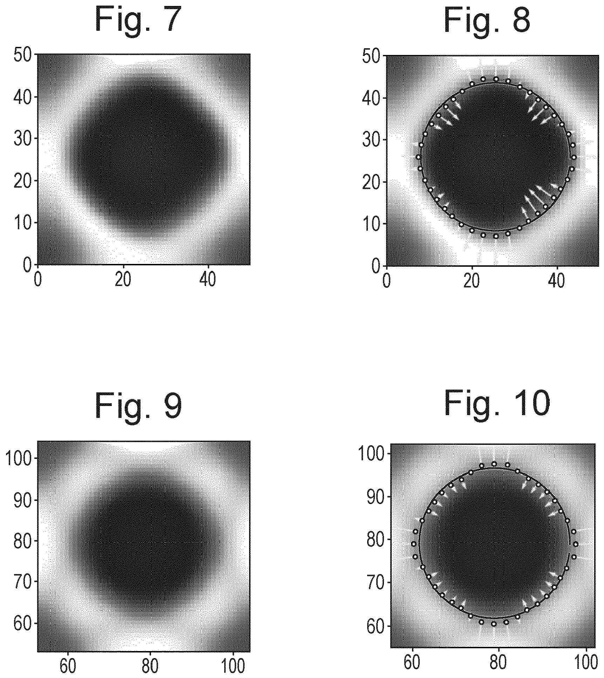

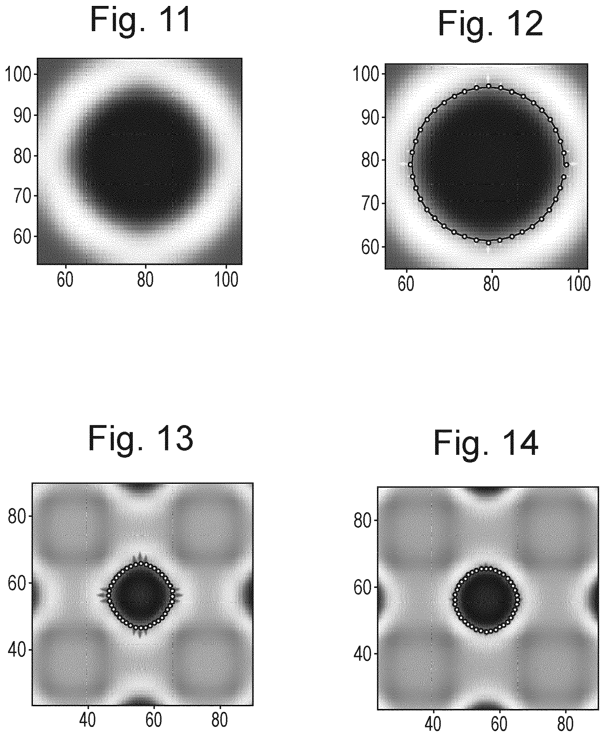

Figs. 7 to 12 show the results that can be achieved with an embodiment the invention. Fig. 7 shows a combination of four scans of a contact hole in different directions without any alignment process. It can clearly be seen that the observed contact hole is closer to a diamond shape than the expected round shape. Fig. 8 is the same figure with analysis overlaid to show a mean average contour error of 0.58 nm, maximum contour error of 1.25 nm and critical dimension (CD) of 35.14 nm. Figs. 9 and 10 are similar views (without and with superimposed analysis) derived from a simulation to reproduce the experimentally observed diamond shape. In the simulation, the maximum contour error (deformation) is 1.4 nm, the mean contour error (deformation) is 0.63 nm and CD was 34.63 nm. Figs. 11 and 12 are similar views based on the same simulation but with an alignment process according to an embodiment applied before combining. In Fig. 11 it can be clearly seen that the result is a much more round contact hole. Analysis as shown in Fig 12 shows a maximum contour deformation decreased to 0.5 nm (i.e. only 36% of the original deformation) and an average contour deformation decreased to 0.11 nm (i.e. only 17% of the original deformation). The CD is now measured at 35.22 nm. These reductions in error are very significant.

Figs 13 and 14 show results that can be achieved with an embodiment in a pattern of dense contact holes suffering from SEM induced charging. Fig. 13 shows a simulated case without alignment between individual scanning directions and Fig. 14 shows the effect with alignment according to an embodiment. In both cases it can be seen that, due to charging, horizontal and vertical 'bands' remain visible. However, with alignment the contact holes are more circular.

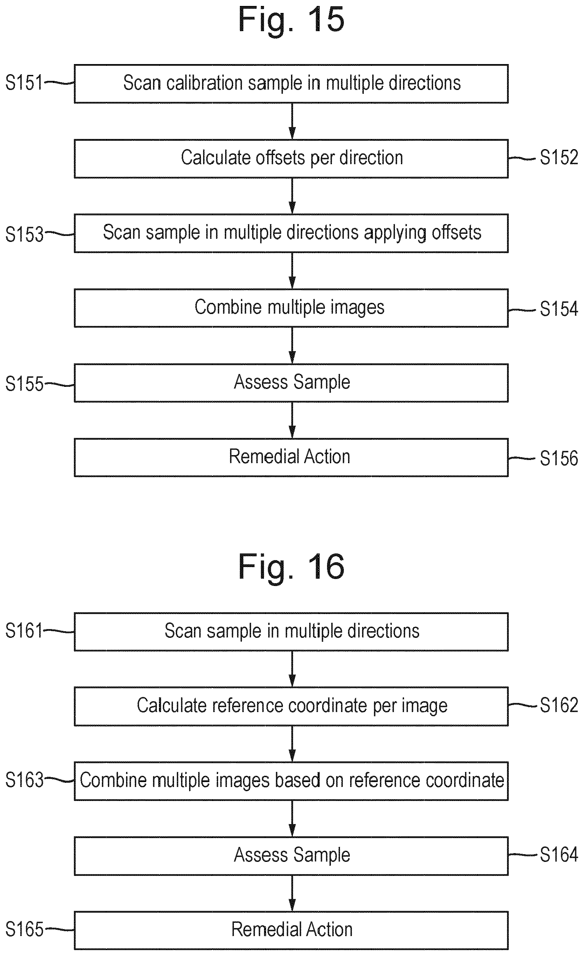

Fig. 15 is a flow diagram of a specific method of an embodiment in which offsets are derived from a calibration process. First a calibration sample is scanned in multiple (e.g. four) directions S151 to generate a plurality of calibration images of the same feature (e.g. a contact hole). The calibration images are analyzed to determine one or more offsets S152. For example the analysis process may comprise performing repeated combinations (averaging of the images) with different offsets until an optimum set of offsets is derived, e.g. one offset for each direction. Regression techniques may be employed to complete the analysis more quickly than a brute force analysis of all possible combinations. The optimum set of offsets is determined using a suitable metric, e.g. sharpness of the combined image.

Having determined suitable offsets, the sample is scanned S153 in the same manner as the calibration sample but with the offsets applied. The offsets can be applied by starting the scans in a position determined by the offset or changing the mapping between sensor output and position in the output image. The latter approach may involve discarding some data output from the sensor or introducing padding. Therefore the different component images output from the SEM have the relevant offset built-in, and can be directly combined S154.

The combined image is then assessed S155 to determine whether there is a defect or other flaw and if necessary remedial action S156 is taken. Remedial action may involve any or all of: adjusting parameters of a lithographic process applied to a subsequent batch of substrates; adjusting a parameter of a subsequent lithographic or other process applied to the sample; stripping the sample and reworking; and discarding the sample.

In the method of Figure 15, the calibration sample may be a known good example of the same structure that is to be examined subsequently, or a similar structure that exhibits similar charging during imaging. The calibration sample may be the first substrate in a batch of substrates. The calibration sample may be a reference structure on the sample substrate as the sample to be measured. By reusing the offsets determined in a calibration process, the method of Fig. 15 is computationally efficient and avoids the need to store the images derived from each of the different directional scans; these can be discarded once combined.

Fig. 16 is a flow diagram of a specific method of an embodiment in which offsets are derived for each feature to be assessed. In the method, the sample is scanned S161 in multiple (e.g. four) directions. Each of the component images is processed to calculate S162 a reference coordinate, e.g. the geometric center or center of gravity of the feature to be assessed. The component images are then combined S163 based on the reference coordinate, e.g. by offsetting one or more of the images so that the reference coordinates are coincident. Alternatively, a process similar to that used in the method of Fig. 15 - using regression to find the combination of images that is sharpest - can be used. Assessment of the sample S164 and remedial action S165 are then performed as in the method of Fig. 15.

Relative dimensions of components in drawings may be altered for clarity. Within the following description of drawings, the same or like reference numbers refer to the same or like components or entities, and only the differences with respect to the individual embodiments are described.

As used herein, unless specifically stated otherwise, the term "or" encompasses all possible combinations, except where infeasible. For example, if it is stated that a component may include A or B, then, unless specifically stated otherwise or infeasible, the component may include A, or B, or A and B. As a second example, if it is stated that a component may include A, B, or C, then, unless specifically stated otherwise or infeasible, the component may include A, or B, or C, or A and B, or A and C, or B and C, or A and B and C.

A non-transitory computer readable medium may be provided that stores instructions for a processor of a controller to carry out image inspection, image acquisition, activating charged-particle source, adjusting electrical excitation of stigmators, adjusting landing energy of electrons, adjusting objective lens excitation, adjusting secondary electron detector position and orientation, stage motion control, beam separator excitation, applying scan deflection voltages to beam deflectors, receiving and processing data associated with signal information from electron detectors, configuring an electrostatic element, detecting signal electrons, adjusting the control electrode potential, adjusting the voltages applied to the electron source, extractor electrode, and the sample, etc. Common forms of non-transitory media include, for example, a floppy disk, a flexible disk, hard disk, solid state drive, magnetic tape, or any other magnetic data storage medium, a Compact Disc Read Only Memory (CD-ROM), any other optical data storage medium, any physical medium with patterns of holes, a Random Access Memory (RAM), a Programmable Read Only Memory (PROM), and Erasable Programmable Read Only Memory (EPROM), a FLASH-EPROM or any other flash memory, Non-Volatile Random Access Memory (NVRAM), a cache, a register, any other memory chip or cartridge, and networked versions of the same.

Aspects of the invention are described in the following numbered clauses:
1. A method of reducing a sample charging effect in a scanning electron microscope (SEM) image, the method comprising:
   obtaining a first SEM image of a target feature on a sample from a first electron beam scan in a first scanning direction;
   obtaining a second SEM image of the target feature on the sample from a second electron beam scan in a second scanning direction different from the first scanning direction;
   aligning the first SEM image and the second SEM image; and
   generating an output image based a combination of the first SEM image and the second SEM image.
2. The method according to clause 1, wherein aligning the first SEM image and the second SEM image comprises applying a position offset to at least one of the first SEM image and the second SEM image.
3. The method according to clause 1, wherein aligning the first SEM image and the second SEM image comprises applying respective position offsets to parts of at least one of the first SEM image and the second SEM image.
4. The method according to clause 2 or 3, wherein the position offset(s) is(are) predetermined.
5. The method according to clause 4, wherein the position offset(s) has(have) been determined by performing calibration scans on a sample having a calibration feature similar to the target feature.
6. The method according to clause 4 or 5, wherein the position offset(s) is(are) applied during the respective one(s) of the first electron beam scan and the second electron beam scan.
7. The method according to clause 2 or 3, wherein the position offset(s) is(are) determined from the first SEM image and the second SEM image.
8. The method according to clause 7, wherein the position offset is determined such that contour lines of the feature in the output image have maximum sharpness.
9. The method according to any preceding clause, wherein the second direction is anti-parallel to the first direction.
10. The method according any preceding clause, further comprising:
   obtaining a third SEM image of a target feature on a sample from a third electron beam scan in a third scanning direction different from the first and second scanning directions; and
   obtaining a fourth SEM image of the target feature on the sample from a fourth electron beam scan in a fourth scanning different from the first second and third scanning directions; wherein
   aligning comprises aligning the third SEM image and fourth SEM image as well as the first SEM image and the second SEM image; and
   the output image is based on a combination of the third SEM image and fourth SEM image as well as the first SEM image and the second SEM image.
11. The method according to clause 10, wherein the fourth direction is anti-parallel to the third direction.
12. The method according to clause 10 or 11, wherein the third direction is orthogonal to the first direction.
13. A method comprising:
   obtaining a plurality of calibration SEM images by scanning a calibration feature in a plurality of different directions using a scanning electron microscope;
   determining one or more positional offsets for one or more of the calibration SEM images from the plurality of calibration SEM images such that the positional offsets can be used to generate an improved output image when combining a plurality of SEM images.
14. A method according to clause 13 further comprising:
   obtaining a plurality of target SEM images by scanning a target feature in the plurality of different directions using a scanning electron microscope and combining the target SEM images to generate an output image, using the positional offsets.
15. A method according to clause 14 wherein the calibration feature and the target feature are on the same sample.
16. A method according to clause 14 wherein the calibration feature and the target feature are on different samples.
17. A method according to any of clauses 14 to 16 wherein the positional offsets are applied during the obtaining of the target SEM images.
18. A method comprising:
   obtaining a plurality of target SEM images by scanning a target feature in the plurality of different directions using a scanning electron microscope; and
   combining the target SEM images to generate an output image;
   wherein one or more positional offsets are applied during respective scans.
19. A method comprising:
   obtaining a plurality of target SEM images by scanning a target feature in the plurality of different directions using a scanning electron microscope; and
   combining the target SEM images using one or more positional offsets to generate an output image.
20. A method according to clause 19 further comprising determining the positional offsets from the target SEM images.
21. A method of measuring a parameter of a target feature on a sample using a scanning electron microscope (SEM) image, the method comprising:
   obtaining a first SEM image of the target feature on the sample from a first electron beam scan in a first scanning direction;
   obtaining a second SEM image of the target feature on the sample from a second electron beam scan in a second scanning direction different from the first scanning direction;
   aligning the first SEM image and the second SEM image;
   generating an output image based a combination of the first SEM image and the second SEM image; and
   determining the parameter from the output image.
22. A method according to clause 21 wherein the parameter is selected from the group consisting of edge placement error and critical dimension.
23. A computer program product comprising a non-transitory computer readable medium having instructions recorded thereon, the instructions, when executed by a controller of a scanning electron microscope, implementing the method of any of the above clauses.
24. A system comprising:
   a scanning electron microscope (SEM) configured to scan with an electron beam and generate an image; and
   a non-transitory machine-readable medium storing instructions which, when executed by a processor, cause the processor in co-operation with the SEM to perform the method of any one of clauses 1 to 22.

It will be appreciated that the embodiments of the present disclosure are not limited to the exact construction that has been described above and illustrated in the accompanying drawings, and that various modifications and changes may be made without departing from the scope thereof. The present disclosure has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. A method of reducing a sample charging effect in a scanning electron microscope (SEM) image, the method comprising:
obtaining a first SEM image of a target feature on a sample from a first electron beam scan in a first scanning direction;
obtaining a second SEM image of the target feature on the sample from a second electron beam scan in a second scanning direction different from the first scanning direction;
aligning the first SEM image and the second SEM image; and
generating an output image based a combination of the first SEM image and the second SEM image.

2. The method according to claim 1, wherein aligning the first SEM image and the second SEM image comprises applying a position offset to at least one of the first SEM image and the second SEM image.

3. The method according to claim 1, wherein aligning the first SEM image and the second SEM image comprises applying respective position offsets to parts of at least one of the first SEM image and the second SEM image.

4. The method according to claim 2 or 3, wherein the position offset(s) is(are) predetermined.

5. The method according to claim 4, wherein the position offset(s) has(have) been determined by performing calibration scans on a sample having a calibration feature similar to the target feature.

6. The method according to claim 4 or 5, wherein the position offset(s) is(are) applied during the respective one(s) of the first electron beam scan and the second electron beam scan.

7. The method according to claim 2 or 3, wherein the position offset(s) is(are) determined from the first SEM image and the second SEM image.

8. The method according to claim 7, wherein the position offset is determined such that contour lines of the feature in the output image have maximum sharpness.

9. The method according to any preceding claim, wherein the second direction is anti-parallel to the first direction.

10. The method according any preceding claim, further comprising:
obtaining a third SEM image of a target feature on a sample from a third electron beam scan in a third scanning direction different from the first and second scanning directions; and
obtaining a fourth SEM image of the target feature on the sample from a fourth electron beam scan in a fourth scanning different from the first second and third scanning directions; wherein
aligning comprises aligning the third SEM image and fourth SEM image as well as the first SEM image and the second SEM image; and
the output image is based on a combination of the third SEM image and fourth SEM image as well as the first SEM image and the second SEM image.

11. The method according to claim 10, wherein the fourth direction is anti-parallel to the third direction.

12. The method according to claim 10 or 11, wherein the third direction is orthogonal to the first direction.

13. A method comprising:
obtaining a plurality of calibration SEM images by scanning a calibration feature in a plurality of different directions using a scanning electron microscope;
determining one or more positional offsets for one or more of the calibration SEM images from the plurality of calibration SEM images such that the positional offsets can be used to generate an improved output image when combining a plurality of SEM images.

14. A method according to claim 13 further comprising:
obtaining a plurality of target SEM images by scanning a target feature in the plurality of different directions using a scanning electron microscope and combining the target SEM images to generate an output image, using the positional offsets.

15. A system comprising:
a scanning electron microscope (SEM) configured to scan with an electron beam and generate an image; and
a non-transitory machine-readable medium storing instructions which, when executed by a processor, cause the processor in co-operation with the SEM to perform the method of claim 1.
